# EUROPEAN PATENT APPLICATION

(11) **EP 4 807 374 A1**
(43) Date of publication of application: **16.09.2026**
(21) Application number: 25163929.0
(22) Date of filing: 14.03.2025
(51) Int. Cl.: G01R 15/20

(54) **CURRENT SENSOR ASSEMBLY, AND PRINTED CIRCUIT BOARD(S) WITH SENSOR DEVICES**

(71) Applicant: Melexis Technologies SA, 2022 Bevaix (CH)
(72) Inventor: GALLOT, Mathieu, 92400 Courbevoie (FR); BERNARD, Loïc, 2022 Bevaix (CH)
(74) Representative: Jacobs, Lambert

(57) **Abstract**

A current sensor assembly (100) comprising: a plurality of electrical conductor portions (20) for conducting electrical currents (Iu, Iv, Iw); each conductor portion having two interconnection portions disposed between two main body portions, the interconnection portions extending in a first direction (X) and spaced apart so to form an opening (25) between them; one or more printed circuit boards (10) comprising at least two lips or protrusions (11) accommodating at least two sensor devices (30); each sensor device being arranged at least partially inside one opening (25), and configured for measuring at least two magnetic field components oriented in a direction (Z) perpendicular to the semiconductor substrate (10) at two sensor locations spaced apart in the second direction (Y). A printed circuit board (10) having at least one cut-out (44) and lip (11) and magnetic sensor device (30). A power invertor comprising such current sensor assembly and/or such a PCB.

## Description

### Field of the invention

The present invention relates to the field of current sensor devices and systems, and in particular to current sensor assemblies comprising a plurality of at least two conductor portions having an opening, and a single printed circuit board having lips (or protrusions) and current sensors mounted on said lips, the lips being inserted in said openings. The present invention also relates to such a printed circuit board (PCB) and to an invertor.

### Background of the invention

Current sensor devices and systems are known in the art. They are used for example to measure and to control the flow of currents in electrical motors, e.g. of electrical vehicles, or in DC-to-AC power convertors (also known as invertors), and the like.

In contrast to for example the power generated by a solar power installation and delivered to the power grid at a constant frequency of about 50 Hz or 60 Hz, the currents that need to be delivered to the coils of an electrical motor of an electrical vehicle typically contain much higher frequencies, e.g. up to 1000 Hz, or up to 1500 Hz, or up to 2000 Hz.

There are many challenges for power delivery systems in electrical vehicles, for example related to weight and compactness, accuracy, long term stability, robustness against positioning errors, robustness against external disturbances, complexity, cost, reliability, safety, mounting tolerances, etc.

US2021311136(A1) discloses a current sensor system comprising a plurality of conductors, each having an aperture, and the apertures of the conductors are aligned with a common reference line, such that a long and narrow printed circuit board (PCB) with multiple sensor devices can be inserted through the different apertures for measurement of the different currents, but almost no room is left for other components.

There is always room for improvements or alternatives.

### Summary of the invention

It is an object of the present invention to provide a current sensor assembly comprising a plurality of at least two conductor portions each having an opening, and a printed circuit board with a plurality of sensor devices, each positioned at least partially in a corresponding opening.

It is an object of embodiments of the present invention to provide such a current sensor assembly where the currents are measured with good accuracy, e.g. in terms of SNR, and/or are highly robust against an external disturbance field, and/or are highly robust against mechanical positioning errors (in particular with respect to the sensor device relative to the openings of the conductors).

It is an object of embodiments of the present invention to provide a current sensor assembly where the currents are measured with an absolute error smaller than ± 5% for frequencies up to 1500 Hz, and/or smaller than ± 4% for frequencies up to 1000 Hz, even without a magnetic shielding, and even without using cross-talk compensation calculations.

It is an object of embodiments of the present invention to provide a current sensor assembly that is less sensitive to mechanical positioning errors of the sensor devices relative to the conductor portions.

It is also an object of the present invention to provide a printed circuit board with a plurality of sensor devices for use in such a current sensor assembly.

It is also an object of the present invention to provide an inverter (or "DC to AC power convertor") comprising such a current sensor assembly and/or such a printed circuit board.

These and other objectives are accomplished by embodiments of the present invention.

According to a first aspect, the present invention provides a current sensor assembly comprising: a plurality of at least two (or at least three) electrical conductor portions for conducting at least two (or at least three) electrical currents (e.g. lu, Iv, Iw), each of said at least two electrical conductor portions having two main body portions, and two interconnection portions disposed between the two main body portions, the two interconnection portions being spaced apart and extending in a first direction (e.g. X) so as to form an opening between them; one or more printed circuit boards located in a virtual plane extending parallel to the first direction (e.g. X) and parallel to a second direction (e.g. Y) perpendicular to the first direction, the one or more printed circuit boards together comprising at least two (or at least three) lips or protrusions, each lip or protrusion accommodating a sensor device; each sensor device (having at least three (or at least four) electrical contacts (e.g. pins or elongated leads) connected to the one or more printed circuit boards; each sensor device being or comprising a semiconductor substrate oriented parallel to the one or more printed circuit boards; each sensor device being arranged at least partially inside the opening of a respective electrical conductor portion; each sensor device comprising a plurality of magnetic sensing elements (e.g. H1,H2; H3,H4; H5,H6) for measuring at least two magnetic field components (e.g. Bz1,Bz2; Bz3,Bz4; Bz5,Bz6) oriented in a third direction (e.g. Z) perpendicular to the semiconductor substrate at two sensor locations spaced apart in the second direction (e.g. Y).

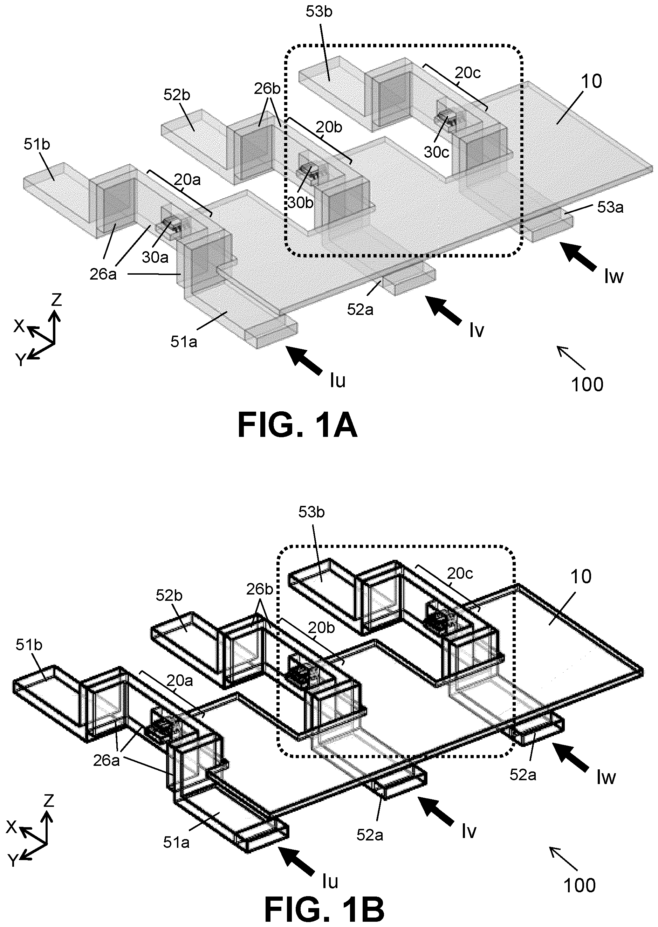

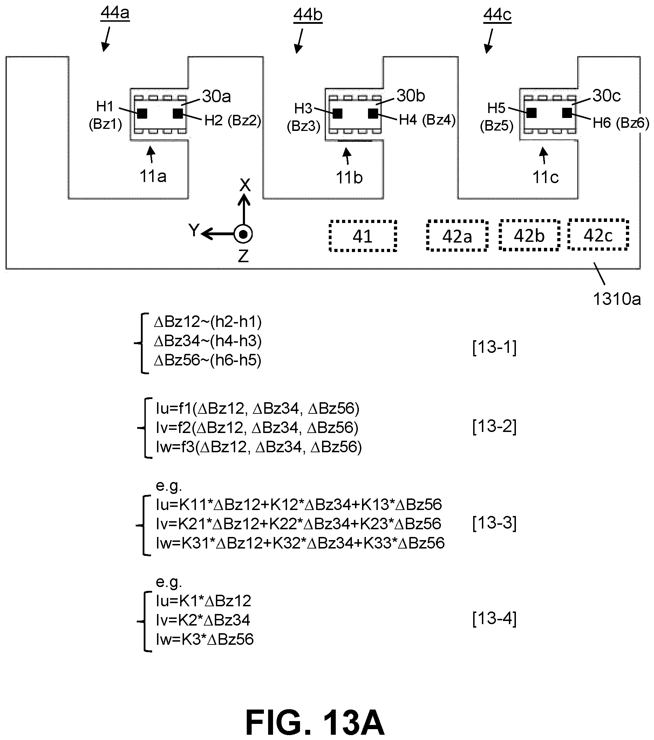

Examples of such a current sensor assembly are illustrated in FIG. 1A to FIG. 2C. Examples of the one or more printed circuit boards that can be used in such assembly are shown in FIG. 13A to FIG. 13E.

An advantage of mounting the semiconductor substrate and/or the packaged device parallel to the one or more PCB's is that so called "di/dt interference" can be reduced. This is particularly advantageous when measuring a strong and a fast varying magnetic field. This is particularly true if a surface mounted package (SMD-package) is used.

The two interconnection portions (e.g. 23, 24) are preferably spaced apart in a direction (e.g. Z) perpendicular to the one or more PCB's. The two interconnection portions may be parallel portions.

In an embodiment, the first interconnection portion has a first cross-sectional area (e.g. A1) in the YZ-plane, and the second interconnection portion has a second cross-sectional area (e.g. A2) in the YZ-plane, and a ratio (A1/A2) is a value in the range from 80% to 120%, or in the range from 85% to 115%, or in the range from 90% to 110%, or in the range from 95% to 105%.

The at least three electrical contacts of the sensor devices may comprise e.g. one ground contact (e.g. GND), one supply contact (e.g. VDD) and one output contact (e.g. OUT).

In an embodiment, each sensor device may comprise at least four electrical contacts (e.g. pins or elongated leads or solder balls or the like).

The sensor devices are preferably "surface-mounted" on the PCB (in contrast to a package having e.g. three long elongated pins oriented perpendicular to the PCB). The package may have a heat-dissipating contact surface in direct contact with an area of the PCB.

In an embodiment, each of the at least two sensor devices comprises a single semiconductor substrate.

In an embodiment, each of the at least two sensor device comprises at least two semiconductor substrates, for example one "main semiconductor substrate", and one "sensor substrate" comprising said at least two magnetic sensor elements. The main substrate may be a CMOS substrate and may comprise at least a biasing and readout circuit and an amplifier, and optionally also a digitizer, and optionally also a digital processing circuit.

The magnetic sensor elements may be integrated in the single substrate or in the main substrate, or may be stacked on the main substrate, or may be integrated in other substrates (also referred to as "sensor substrate") electrically connected to the main substrate.

Preferably at least one, or each of the one or more printed circuit board (PCB) has at least four layers, or at least six layers.

Optionally, each sensor device may comprise a plastic or a ceramic package, but that is not absolutely required, and it is also possible to mount the semiconductor substrate on the printed circuit board directly (known in the art as "chip on board").

In an embodiment, the current sensor assembly comprises only a single printed circuit board comprising said at least two lips and said at least two sensor devices, each sensor device mounted on a respective lip or protrusion.

In an embodiment, the current sensor assembly comprises only a single printed circuit board comprising said at least three lips and said at least three sensor devices, each sensor device mounted on a respective lip or protrusion.

In an embodiment, each of the at least two electrical conductor portions is an integral part of a U-shaped profile, e.g. as illustrated in FIG. 1A to FIG. 2C.

In an embodiment, the at least two electrical conductor portions comprise a first electrical conductor portion (e.g. 20a) and a second electrical conductor portion (e.g. 20b); and the first electrical conductor portion has a first end electrically connected to a first busbar portion (e.g. 51a), and a second end electrically connected to a second busbar portion (e.g. 51b) for electrically interconnecting said first and second busbar portion and for measuring a first current (e.g. lu) flowing through said first and second busbar portion; and wherein the second electrical conductor portion (e.g. 20b) has a third end electrically connected to a third busbar portion (e.g. 52a), and a fourth end electrically connected to a fourth busbar portion (e.g. 52b) for electrically interconnecting said third and fourth busbar portion and for measuring a second current (e.g. Iv) flowing through said third and fourth busbar portion.

The interconnection portions may be mechanically and electrically connected to the busbar portions directly or indirectly, e.g. by soldering or welding or by means of one or more bolts or rivets or other fastening means.

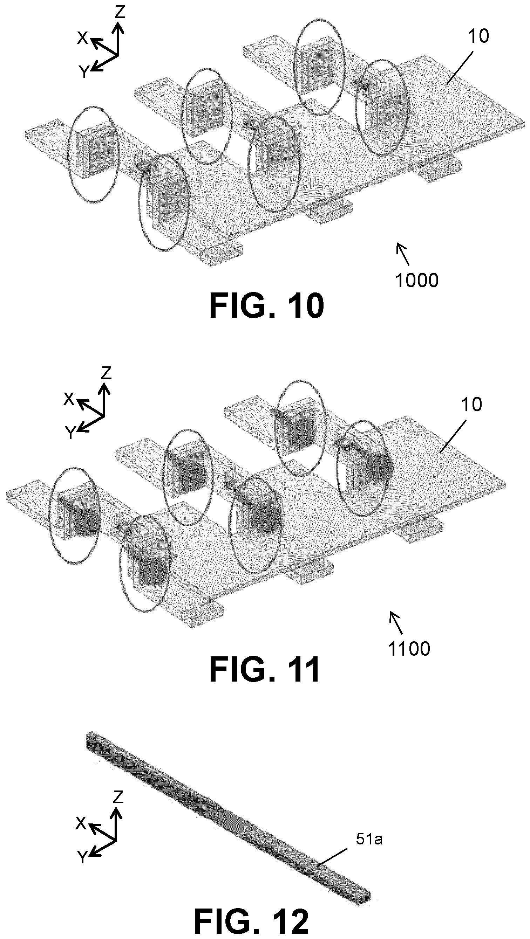

In an embodiment, the busbar portions are bent at their ends so as to form a cross-section with an L-shape in the XZ-plane, and the electrical conductor portions are bent at their ends so as to form a U-shape in the XY-plane, and the ends of said L-shapes and the ends of said U-shapes are mechanically and electrically connected to each other, for example as illustrated in FIG. 10 or FIG. 11.

In another embodiment (not shown in detail, but see e.g. FIG. 12), the first electrical conductor portion is an integral part of a first busbar, and the second electrical conductor portion is an integral part of a second busbar, and the first and second busbar are locally twisted about their longitudinal axes, e.g. over an angle of about 90°.

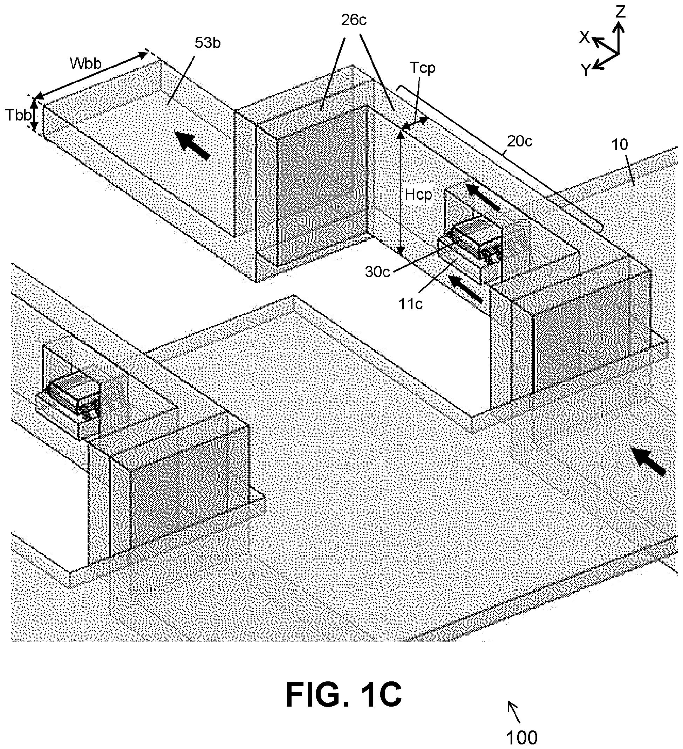

Each of the at least two electrical conductor portions (e.g. 20a, 20b) may have a rectangular cross-section in a plane YZ, with a height Hcp measured in the Z-direction, and a thickness (Tcp) measured in the Y-direction; wherein a ratio Hcp/Tcp is at least 1.25, or at least 1.5, or at least 1.75, or at least 2.0, or at least 2.5, or at least 3.0 or at least 4.0, or at least 5.0. For example as illustrated in FIG. 1C, where the electrical conductor portions are mainly oriented upright, e.g. in a vertical plane.

The first and second busbar portions (e.g. 51a, 51b, 52a, 52b) may have a rectangular cross-section in a plane YZ with a thickness Tbb measured in the Z-direction, and a width Wbb measured in the Y-direction; wherein a ratio of Wbb/Tbb is at least 1.25, or at least 1.5, or at least 1.75, or at least 2.0, or at least 2.5, or at least 3.0 or at least 4.0, or at least 5.0. For example as illustrated in FIG. 1C, where the busbar portions are mainly oriented horizontally, e.g. in a plane XY.

In preferred embodiments (Wbb/Tbb) is at least 3.0 and (Hcp/Tcp) of at least 3.0, meaning that the electrical conductor portions (e.g. 20a, 20b) are oriented substantially perpendicular to the busbar portions.

In an embodiment, Wbb is equal to Hcp, and Tbb is equal to Tcp.

In an embodiment, each of the first and second electrical conductor portion (e.g. 20a, 20b) is a planar metallic profile extending mainly in the first direction (e.g. X) and the third direction (e.g. Z); and wherein each of the first, second, third and fourth busbar portion (e.g. 51a, 51b, 52a, 52b) is a planar metallic profile extending mainly in the first direction (e.g. X) and the second direction (e.g. Y).

In an embodiment, said electrical conductor portions (e.g. 20a, 20b) are oriented substantially perpendicular to said busbar portions (e.g. 51a, 51b, 52a, 52b); and wherein said one or more printed circuit boards are oriented substantially perpendicular to said electrical conductor portions (e.g. 20a, 20b) and substantially parallel to said busbar portions (e.g. 51a, 51b, 52a, 52b).

In certain embodiments, the lips or protrusions have a periphery which is connected to the one or more PCB(s over an imaginary line segment, and the remainder of the periphery defines a bulb shape or a bulging shape which is free (i.e. is not connected to the one or more PCB's).

Each lip extends in the second direction (Y), preferably by at least 4.0 mm and at most 30 mm, or at most 25 mm, or at most 20 mm, or at most 15 mm.

In an embodiment, each lip has a rectangular shape having a width (e.g. w11) smaller than or equal to a distance (e.g. L23) between the two body portions (e.g. 21, 22).

In this case, the shape of the rectangular lip has four sides, one side being connected to the printed board, and three sides being free.

In an embodiment, each lip has a trapezoidal shape having a largest width smaller than or equal to a distance between the two body portions.

In an embodiment, each lip has a dome shape or a bulb shape or a semi-elliptical shape with a largest dimension measured in the X-direction which is smaller than or equal to a distance between the two body portions.

In an embodiment, at least one, or at least two, or all of the one or more printed circuit boards has at least one (or at least two or at least three) cut-out (e.g. 44a, 44b) having a predefined shape selected from the group consisting of: a U-shape, an L-shape, a rectangular shape, for example as illustrated in FIG. 13A to FIG. 13E.

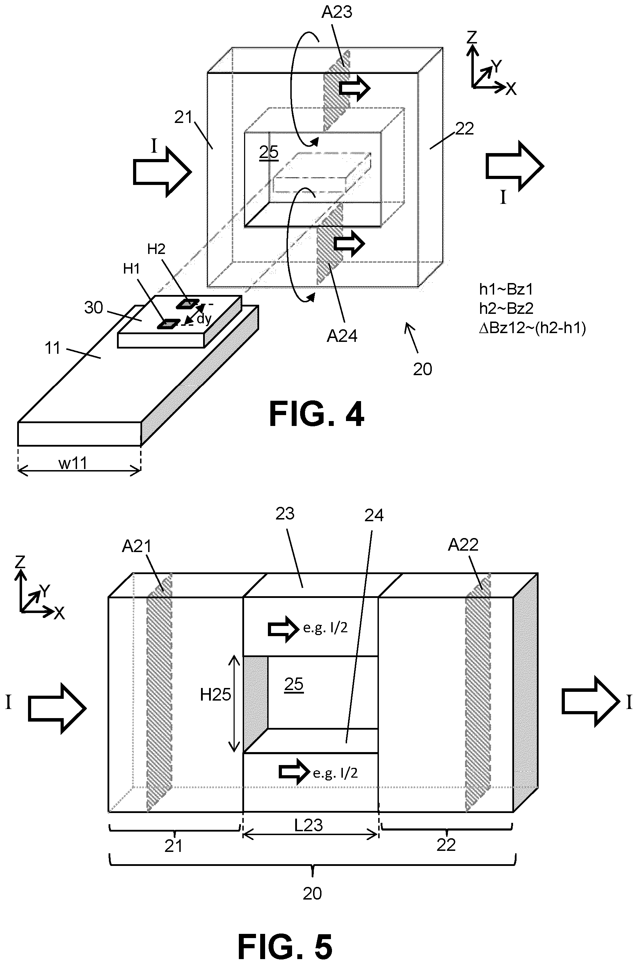

In an embodiment, each of said at least two sensor devices comprises at least two horizontal Hall elements (e.g. H1, H2) spaced apart in the second direction (e.g. Y), e.g. as illustrated in FIG. 4, FIG. 6, FIG. 13A to FIG. 13E.

As mentioned above, the magnetic sensor elements are configured for measuring a first magnetic field component (e.g. Bz1) oriented in the Z-direction at a first sensor location, and for measuring a second magnetic field component (e.g. Bz2) oriented in the Z-direction at a second sensor location, spaced from the first sensor location in the Y-direction.

The semiconductor substrate may be further configured for determining a difference (e.g. ΔBz) between the measured magnetic field components.

The semiconductor substrate may be further configured for amplifying and/or digitizing the difference signal (e.g. ΔBz). The amplified and optionally digitized difference signal may be output. Optionally the digitized difference signal is furthermore scaled using a predefined scaling factor to convert the value of the magnetic field gradient into a current value. The scaling factor may be determined during a calibration procedure, and may be stored in a non-volatile memory during said calibration procedure, and may be retrieved from said non-volatile memory during actual use. This scaled value may be output instead of, or in addition to the digital difference signal mentioned above.

In an embodiment, at least one of the one or more printed circuit boards further comprises a controller device (e.g. 41) electrically connected to each of said at least two (or at least three) sensor devices.

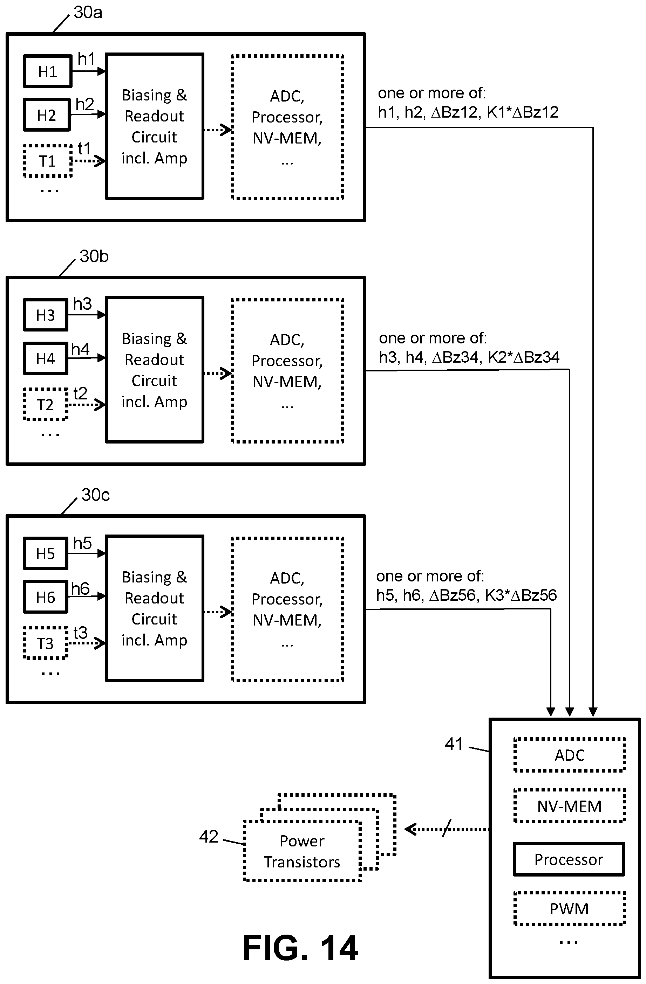

An example of such an arrangement is illustrated in FIG. 14. Examples are also shown in FIG. 13A to FIG. 13E. In case the sensor devices are mounted on separate printed circuit boards, the printed circuit boards may be electrically interconnected in known manners, e.g. using electrical connectors and wires or cables or using flex connectors and flex cables.

The controller device may be a programmable controller, or a chip (packaged semiconductor device) with a processing circuit.

In an embodiment, one or more or each of the sensor devices further comprises a processing circuit, e.g. an analog or digital processing circuit, e.g. comprising a programmable digital processor.

In an embodiment, each of the at least two sensor devices is configured for providing a value indicative of (e.g. proportional to) a magnetic field difference (e.g. ΔBz12, ΔBz34, ΔBz56) to the controller device (e.g. 41); and the controller device is configured for receiving at least two or at least three of these values from the sensor devices, and for determining at least a first and a second current (Iu, Iv) and optionally also a third current, based on the received values.

For example in accordance with the formulas of equations of FIG. 13A.

The controller device may be configured for reducing or substantially eliminating cross-talk between the various sensor devices.

The sensor devices may, for example, provide a value derived from a difference (ΔBz) between the measured magnetic field component values, e.g. a value proportional thereto, e.g. using a scaling factor which is determined during a calibration procedure. The scaling factor may be chosen such that the scaled value is indicative of an individual current flowing through the respective electrical conductor portions or busbars, e.g. in case the other currents are zero.

In an embodiment, the controller device is configured for determining said first and said second current as a linear combination of the received at least two or at least three values, (e.g. magnetic field difference values ΔBz12, ΔBz34, ΔBz56, or values proportional hereto) using predefined coefficients.

These predefined coefficients may be determined by simulation, or during a calibration procedure, and may be stored in a non-volatile memory. The non-volatile memory may be embedded to the controller device, or may be outside of the controller device but communicatively connected thereto.

In an embodiment, the sensor devices provide magnetic field difference values (ΔBz12, ΔBz34, ΔBz56), and the predefined coefficients take into account a scaling factor to convert ΔBz to a current value (see e.g. the set of formulas [13-4]), and preferably also take into account cross-talk compensation. (see e.g. the set of formulas [13-3]).

In an embodiment, the sensor devices provide scaled values corresponding to individual current values (see in accordance with a respective formulas from the set of formulas [13-4]), and the controller device takes care of cross-talk compensation (e.g. using the set of formulas [13-3] with K11=1.0 and K22=1.0 and K33=1.0).

The one or more printed circuit boards may optionally further comprises a plurality of power transistors.

The controller device may have a plurality of inputs connected to the sensor devices for receiving signals indicative of the currents flowing through the conductor portions, and may have a plurality of outputs connected to a plurality of power switches, and may be configured for selectively activating and deactivating the power switches based on the measured currents, e.g. for driving an electric motor.

In an embodiment, the current sensor assembly further comprises a plurality of power transistors, which are located on-board (i.e. on the same PCB that contains the controller device) or off-board (i.e. not on the same PCB, but on another PCB, e.g. as part of a module connected to the PCB via a connector and a plurality of electrical wires).

The power transistors may be configured in a half-H bridge or a dual-H-bridge configuration.

The current sensor assembly may comprise at least four or at least six power transistors.

The controller device may be configured to drive the power transistors (in known manners), based on the measured currents, for example for allowing the current to flow through one or more coils connected to the current sensor assembly.

In an embodiment, the current sensor assembly comprises: a first electrical conductor portion (e.g. 20a) for conducting a first current (e.g. lu), and a first sensor device (e.g. 30a) arranged at least partially inside an opening (e.g. 25a) of the first electrical conductor portion (e.g. 20a); and a second electrical conductor portion (e.g. 20b) for conducting a second current (e.g. Iv), and a second sensor device (e.g. 30b) arranged at least partially inside an opening (e.g. 25b) of the second electrical conductor portion (e.g. 20b); and a third electrical conductor portion (e.g. 20c) for conducting a third current (e.g. Iw), and a third sensor device (e.g. 30c) arranged at least partially inside an opening (e.g. 25c) of the third electrical conductor portion (e.g. 20c).

Such an assembly may for example be a three-phase current sensor system.

In an embodiment, the plurality of electrical conductor portions (e.g. 20a, 20b, 20c) are spaced apart in the second direction (e.g. Y); and the two interconnection portions (e.g. 23, 24) of each individual conductor portion (e.g. 20a, 20b, 20c) are spaced apart in the third direction (e.g. Z); and the lips (e.g. 11a, 11b, 11c) of the one or more printed circuit boards extend in the second direction (e.g. Y), and are spaced apart in the second direction (e.g. Y).

An example of such an assembly is illustrated in FIG. 1A to FIG. 2C, and in FIG. 13A to FIG. 13E

In an embodiment, the three lips are substantially located on a single virtual line, but that is not absolutely required.

It is a major advantage of this assembly that the at least two (e.g. two or three) currents can be measured in a manner which is highly insensitive to cross-talk, even without using a magnetic shielding, in a very simple manner, e.g. using a simple matrix-calculation.

In an embodiment, the sensor devices are packaged in a surface-mount package, e.g. an SOIC-package, or a QFN package, or a DFN package or a SON Package.

The abbreviations stand for QFN (Quad Flat No Lead package), DFN (Dual Flat No Lead package), SON (Small Outline No-Lead package). Using a package without long elongated leads offers the advantage that it may offer better isolation (e.g. less capacitive coupling, less interferences) between the busbar and the electrical leads, resulting in a higher accuracy.

According to a second aspect, the present invention also provides a printed circuit board (PCB) having a surface extending in a first direction (e.g. X) and a second direction (e.g. Y) perpendicular to the first direction; and comprising at least two (e.g. two or three) cut-outs (e.g. 44a, 44b, 44c) and at least two (e.g. two or three) lips or protrusions (e.g. 11a, 11b, 11c) extending in the second direction (e.g. Y), and being spaced apart in the second direction (e.g. Y); each lip or protrusion accommodating a sensor device (e.g. 30a, 30b, 30c); each sensor device comprising a plurality of magnetic sensor elements (e.g. H1,H2; H3,H4; H5,H6) configured for measuring at least two magnetic field components (e.g. Bz1, Bz2; Bz3,Bz4; Bz5,Bz6) oriented in a third direction (e.g. Z) perpendicular to the printed circuit board at two sensor locations which are spaced apart in the second direction (e.g. Y).

It is contemplated that the PCB and/or the sensor devices can have any or all of the characteristics of the PCB and/or sensor device of the assembly described above. For example, the PCB main comprise a controller device and/or power transistors; each sensor device may comprise one or two semiconductor substrates oriented parallel to the printed circuit board; the sensor device may be packed in etc.

In an embodiment, each sensor device has at least three or at least four electrical contacts (e.g. pins or elongated leads) connected to the printed circuit board.

Preferably each sensor devices is packaged in an SOIC-package, or a QFN package, or a DFN package or a SON Package.

In an embodiment, the lips (e.g. 11a, 11b, 11c) have a rectangular shape or a trapezoidal shape or a triangular shape or a dome shape or a bulb shape or a semi-elliptical shape.

In an embodiment, the cut-outs (e.g. 44a, 44b, 44c) have a predefined shape selected from the group consisting of: a U-shape, an L-shape, a rectangular shape.

In an embodiment, the PCB further comprises a controller device (e.g. 41) electrically connected to the at least two (or at least three) sensor devices; and optionally further comprising at least two (or at least three) power transistors connected to said controller device.

According to a third aspect, the present invention also provides a power inverter comprising a current sensor assembly according to the first aspect, and/or comprising a PCB according to the second aspect.

In an embodiment, the power convertor comprises only one PCB, in other words, the PCB with protrusions and lips and sensor devices also contains other electronics of the power convertor, e.g. a power controller, power switches, etc.

Particular and preferred aspects of the present invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

**FIG. 1A** shows an illustrative example of a current sensor assembly proposed by the present invention, in perspective view.
**FIG. 1B** shows the current sensor assembly of FIG. 1A as a line drawing.
**FIG. 1C** shows a portion of the current sensor assembly of FIG. 1A as a dithered image.
**FIG. 1D** shows a variant of FIG. 1A comprising two printed circuit boards.
**FIG. 1E** shows another variant of FIG. 1A comprising three printed circuit boards.
**FIG. 2A** shows a top view of the current sensor assembly of FIG. 1A.
**FIG. 2B** shows the current sensor assembly of FIG. 2A as a line drawing.
**FIG. 2C** shows the current sensor assembly of FIG. 2A as a dithered image.
**FIG. 3A** shows a side view of the current sensor assembly of FIG. 1A.
**FIG. 3B** shows the current sensor assembly of FIG. 3A as a line drawing.
**FIG. 4** shows an enlarged view of how a sensor device mounted on a lip of a PCB, can be inserted in an opening formed in an electrical conductor portion, as may be done when assembling the current sensor assembly of FIG. 1A.
**FIG. 5** shows an enlarged view of an electrical conductor portion that can be used in embodiments of the present invention.
**FIG. 6** gives an impression of the magnetic field lines caused by the currents flowing in the interconnection portions 23, 24 of FIG. 5, in a virtual plane perpendicular to the first direction (X), and shows an illustrative example of two sensor elements for measuring magnetic field components oriented in the Z-direction.
**FIG. 7** shows a graph with simulation results showing the magnitudes of the three magnetic difference signals (ΔBz) as may be measured by the three sensor devices of FIG. 1A, for currents having a predefined amplitude and a frequency ranging from 100 Hz to 1500 Hz, without using magnetic shielding and without cross-talk compensation, taking into account mechanical tolerances.
**FIG. 8** shows a graph with simulation results showing the phase shift of the three magnetic difference signals (ΔBz) as may be measured by the three sensor devices of FIG. 1A, for currents having a predefined amplitude and a frequency ranging from 100 Hz to 1500 Hz, without using magnetic shielding and without cross-talk compensation, taking into account mechanical tolerances.
**FIG. 9** shows a graph with simulation results showing the amount of cross-talk of the three magnetic difference signals (ΔBz) as may be measured by the three sensor devices of FIG. 1A, for currents having a predefined amplitude and a frequency ranging from 100 Hz to 1500 Hz, without using magnetic shielding and without cross-talk compensation, taking into account mechanical tolerances.
**FIG. 10** is an illustrative example of a variant of FIG. 1A wherein the electrical conductor portions are soldered or welded to the busbar portions.
**FIG. 11** is an illustrative example of a variant of FIG. 1A wherein the electrical conductor portions are connected to the busbar portions using fastening means like bolts or rivets or the like.
**FIG. 12** is an illustrative example of a busbar that is twisted about its longitudinal axis, as may be used in embodiments of the present invention.
**FIG. 13A to FIG. 13E** show illustrative examples of one or more printed circuit boards with on or more sensor devices mounted thereon, that may be used in embodiments of the present invention.
**FIG. 14** is a schematic block-diagram of an electrical circuit comprising three sensor devices and a control device connected thereto, as may be used in embodiments of the present invention.

The drawings are only schematic and are non-limiting. In the drawings, the size of some of the elements may be exaggerated and not drawn on scale for illustrative purposes. Any reference signs in the claims shall not be construed as limiting the scope. In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

The same or similar reference numerals (modulo 100) may be used to indicate same or similar structural features in different embodiments.

In this document, unless explicitly mentioned otherwise, the term "magnetic sensor device" or "sensor device" refers to a device comprising at least two "magnetic sensor elements", preferably integrated in a semiconductor substrate. The sensor device may be comprised in a package, also called "chip", although that is not absolutely required.

In this document, the term "sensor element" or "magnetic sensor element" or "magnetic sensor" can refer to a component or a group of components or a sub-circuit or a structure capable of measuring a magnetic quantity, such as for example a magneto-resistive (MR) element, an AMR element, a GMR element, a TMR element, an XMR element, a horizontal Hall plate, a vertical Hall plate, a Wheatstone-bridge containing at least one (but preferably four) magneto-resistive elements, etc. or combinations hereof.

Embodiments of the present invention are typically described using an orthogonal coordinate system which is fixed to the semiconductor substrate, and having three axes X, Y, Z, where the X and Y axis are parallel to the substrate, and the Z-axis is perpendicular to the substrate.

In this document, the expression "in-plane component of a magnetic field vector" and "projection of the magnetic field vector in the sensor plane" mean the same. If the sensor device is or comprises a semiconductor substrate, this also means a "magnetic field component parallel to the semiconductor plane". These components are typically referred to herein as Bx, By.

In this document, the expression "out-of-plane component of a magnetic field vector" and "Z component of the vector" and "projection of the vector on an axis perpendicular to the sensor plane" mean the same. This component is typically referred to herein as Bz.

In this application, horizontal Hall plates are typically referred to by H1, H2, etc., signals obtained from horizontal Hall plates are typically referred to by h1, h2, etc.

In the context of this document, the terms "lip" and "protrusion" mean the same, and they refer to an extending portion or a bulging portion of a printed circuit board, e.g. an elongated rectangular or trapezoidal portion, but other shapes are also possible, such as e.g. a triangular shape or a semi-elliptical shape, or an omega-shape, etc.

In this document, the symbol ~ means "is proportional to", unless it is clear from the context that something else is meant.

The present invention relates to current sensor assemblies comprising a plurality of conductor portions with openings, and comprising a plurality of sensor devices positioned at least partially inside these openings, e.g. as illustrated in FIG. 1A, FIG. 1C, FIG. 12. The sensor devices may be mounted on one more more printed circuit boards having lips and protrusions.

The present invention also relates to a printed circuit board for use in such a current sensor assembly, wherein the PCB comprises one or more cut-outs, and one or more lips or protrusions, and one or more sensor devices mounted on said lips, e.g. as illustrated in FIG. 13A to FIG. 13E.

The present invention also relates to an inverter (not explicitly shown) comprising such a current sensor assembly, and/or comprising such one or more printed circuit boards.

### Referring to the Figures.

**FIG. 1A** shows an illustrative example of a current sensor assembly 100, in perspective view.

The current sensor assembly 100 of FIG. 1A comprises: three electrical conductor portions 20a, 20b, 20c, and a printed circuit board 10 comprising three sensor devices 30a, 30b, 30c.

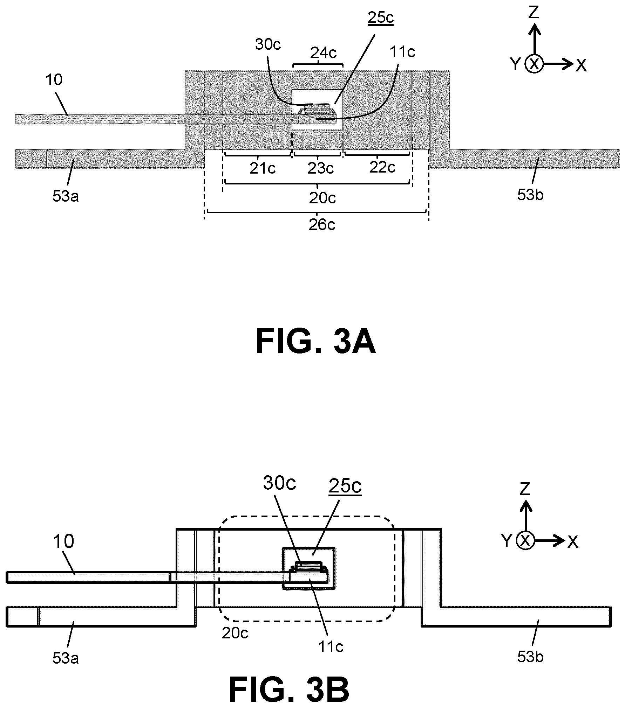

Each electrical conductor portion 20 is configured for conducting a respective electrical current lu, Iv, Iw., and comprises two main body portions 21, 22, and two interconnection portions 23, 24 disposed between the two main body portions 21, 22 (e.g. as illustrated in FIG. 3A, FIG. 10 and FIG. 11). The two interconnection portions 23, 24 extend in a first direction X, and are spaced apart in the Z-direction so as to form an opening 25 between them.

The printed circuit board 10 of FIG. 1A extends in the first direction X and in a second direction Y perpendicular to the first direction X, and comprises three lips or protrusions 11a, 11b, 11c (e.g. as illustrated in FIG. 1C). Each of the three lips or protrusions 11a, 11b, 11c accommodates a respective sensor device 30a, 30b, 30c. Each sensor device 30a, 30b, 30c is or comprises a semiconductor substrate 31 (e.g. as illustrated in FIG. 12) oriented parallel to the printed circuit board 10. Each sensor device 30 is arranged at least partially inside the opening 25 of a respective electrical conductor portion 20. Each sensor device 30 comprises a plurality of magnetic sensing elements (e.g. H1,H2; H3,H4; H5,H6 as illustrated in FIG. 13A) for measuring at least two magnetic field components (e.g. Bz1,Bz2; Bz3,Bz4; Bz5,Bz6) oriented in a third direction Z perpendicular to the semiconductor substrate 10 at two sensor locations spaced apart in the second direction Y.

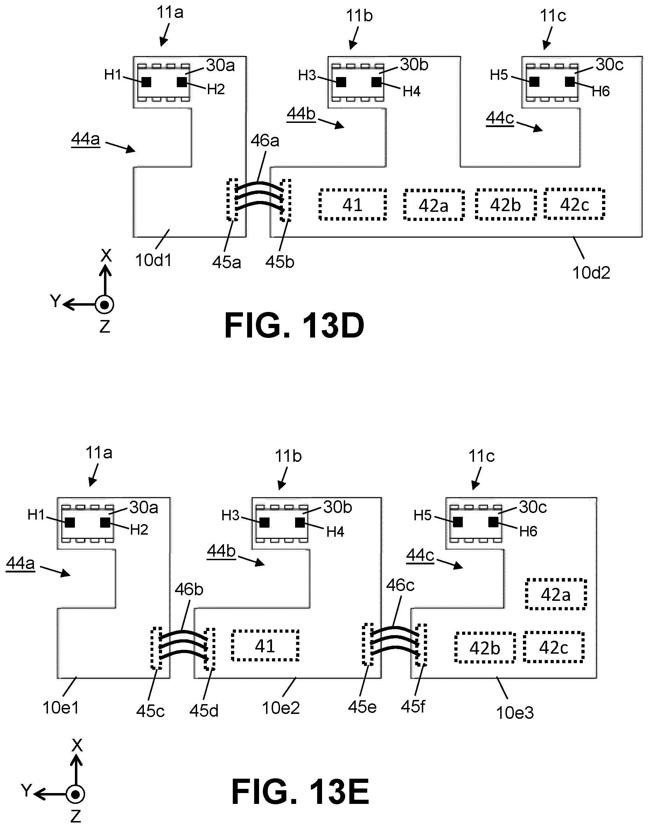

It is an important advantage of this arrangement that a single printed circuit board (PCB) may be used for accommodating and interconnecting the three sensor devices, and for positioning them inside the openings of the conductor portions 20 in a fast and easy manner; and that the PCB can have a size which is larger (e.g. much larger) than the rectangular area defined by the electrical conductor portions 20a, 20b, 20c, allowing other components to be mounted on the PCB that contains the sensor devices. This may even allow in certain applications, (e.g. certain inverter applications) that the PCB that contains the sensor devices is the only PCB of the inverter. The present invention is however not limited to an assembly comprising a single printed circuit board, and may comprise more than one printed circuit board (e.g. as illustrated in FIG. 13D and FIG. 13E).

The two sensor locations may be situated inside or outside of the opening 25.

The sensor devices 30 may be surface mounted components.

The sensor devices may have at least three or at least four electrical contacts, e.g. pins or elongated leads, connected to the printed circuit board 10.

The electrical conductor portions 20a, 20b, 20c may be integral parts of U-shaped conductor profiles 26a, 26b, 26c.

The electrical conductor portions 20a, 20b, 20c or said U-shaped conductor profiles may be arranged between two corresponding busbar portions 51a,51b; 52a,52b; 53a,53b, and electrically connected thereto in known manners, e.g. by soldering, by welding, or using fastening means such as bolts or rivets.

The electrical conductor portions 20a, 20b, 20c have the same cross-section as the busbars, but oriented upright (e.g. mainly in the XZ plane), whereas the busbar portions 51a, 51b, 52a, 52b, etc. may be oriented mainly lying (e.g. in the XY-plane).

In the particular example shown in FIG. 1A, the busbar portions 56 are bent upwards at their ends so as to form a cross-section with an L-shape (seen in the XZ-plane), and the electrical conductor portions 20 are bent at their ends so as to form a U-shape (seen in the XY-plane), and the ends of said L-shapes and the ends of said U-shapes are mechanically and electrically connected to each other, for example by welding or soldering or using bolts or rivets, e.g. as illustrated in FIG. 10 or FIG. 11.

The current sensor assembly of FIG. 1A comprises three electrical conductor portions 20a, 20b, 20c, but the present invention is not limited thereto, and will also work for a current sensor assembly comprising only two electrical conductor portions, e.g. 20a, 20b.

**FIG. 1B** shows the current sensor assembly 100 of FIG. 1A as a line drawing.

**FIG. 1C** shows an enlarged view of a portion of the current sensor assembly 100 of FIG. 1A and FIG. 1B, as a dithered image (provided for illustrative purposes).

Each of the electrical conductor portions 20 may have a rectangular cross-section in a plane YZ, with a height Hcp measured in the Z-direction, and a thickness Tcp measured in the Y-direction. A ratio Hcp/Tcp of the height and the thickness of the electrical conductor portions 20 is preferably at least 1.25, or at least 1.5, or at least 1.75, or at least 2.0, or at least 2.5, or at least 3.0 or at least 4.0, or at least 5.0. The electrical conductor portions, at least a central portion thereof containing the opening 25, are preferably oriented in an upright position, perpendicular to the XY-plane.

The first and second busbar portions 51a,51b; 52a,52b; 53a,53b may have a rectangular cross-section in a plane YZ with a thickness Tbb measured in the Z-direction, and a width Wbb measured in the Y-direction. A ratio Wbb/Tbb of the width and the thickness of the buspar portions is preferably at least 1.25, or at least 1.5, or at least 1.75, or at least 2.0, or at least 2.5, or at least 3.0 or at least 4.0, or at least 5.0. The busbar portions are preferably mainly oriented horizontally, e.g. in a plane XY.

In preferred embodiments the ratio Wbb/Tbb) is at least 3.0 and the ratio Hcp/Tcp is at least 3.0, meaning that the electrical conductor portions 20 (or at least a central portion thereof) are mainly oriented perpendicular to the busbar portions (not considering the interconnection of the bus bar portions with the conductor portions).

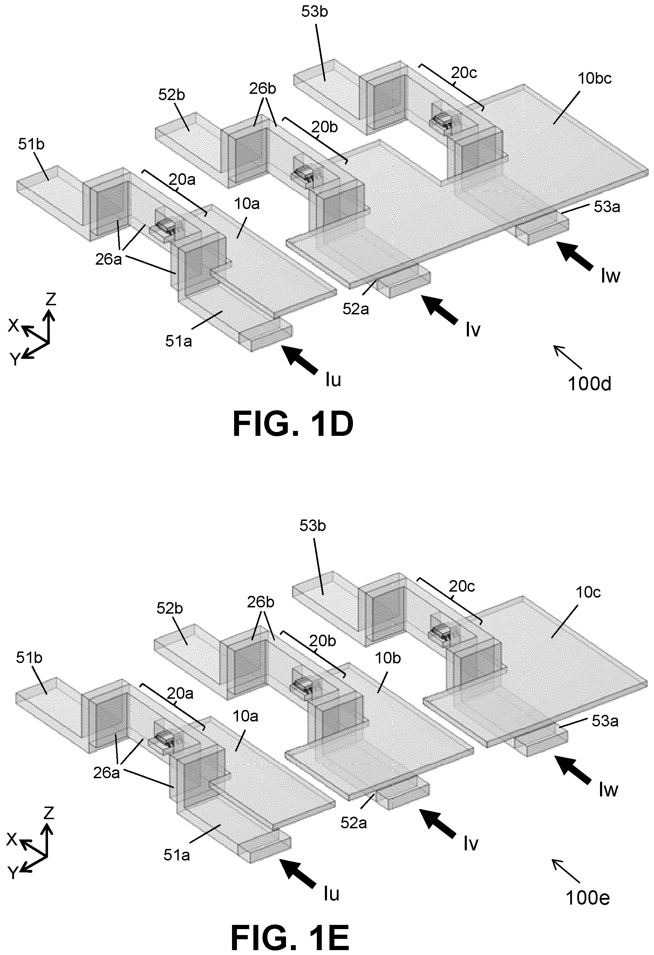

**FIG. 1D** shows a variant of FIG. 1A comprising two printed circuit boards 10a, 10bc. The board 10a has one lip and one cut-out and one sensor device, wherein the printed circuit board 10bc has two lips and two cut-outs and two sensor devices. The two PCBs 10a, 10bc may be electrically interconnected and may comprise further components, not shown in FIG. 1D, but see e.g. FIG. 13D.

**FIG. 1E** shows another variant of FIG. 1A comprising three printed circuit boards 10a, 10b, 10c, each comprising one lip and one cut-out and one sensor device. While not shown in FIG. 1E, these PCBs are preferably electrically interconnected and may comprise further components.

The invention will be further described mainly for an assembly having a single PCB as illustrated in FIG. 1A, for ease of the description.

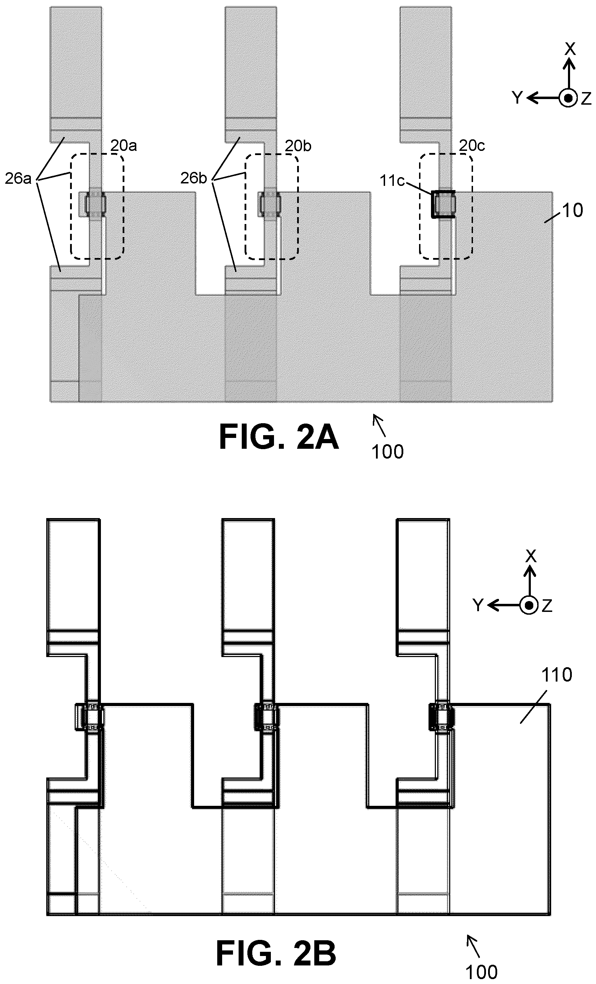

**FIG. 2A** shows a top view of the current sensor assembly 100 of FIG. 1A.

In the example, it is clearly shown that the electrical conductor portions 20 are integral parts of U-shaped profiles, although that is not absolutely required.

In the example shown, the three U-shapes are oriented with their "bridge part" or "central part" situated on the right side of the Fig, and the "legs" of the U-shape extending to the left side, but that is not absolutely required for the invention to work.

In the example shown, the lips or protrusions, e.g. 11c have a rectangular shape, but other shapes can also be used, e.g. a trapezoidal shape, a dome-shape, a bulb shape, a semi-elliptical shape or a bulging shape.

In the example shown, each lip 11 extends in the second direction Y, preferably by at least 4.0 mm and at most 30 mm, or at most 25 mm, or at most 20 mm, or at most 15 mm.

**FIG. 2B** shows the current sensor assembly of FIG. 2A as a line drawing.

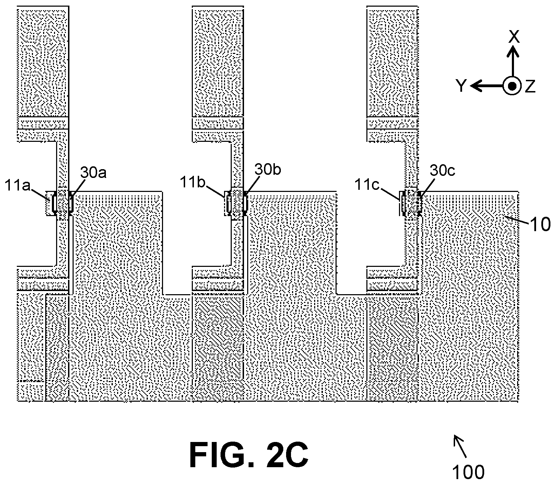

**FIG. 2C** shows the current sensor assembly of FIG. 2A as a dithered image (provided for illustrative purposes).

**FIG. 3A** shows a side view of the current sensor assembly of FIG. 1A, when looking in the Y-direction. This picture shows (inter alia) that:
- the printed circuit board 10 is oriented parallel to the busbar portions 53a, 53b;
- the electrical conductor portion 20c comprises two main body portions 21c, 22c and two interconnection portions 23c, 24c disposed between the two main body portions, and spaced apart from each other in the Z-direction, so as to form an opening 25c;
- the electrical conductor portion 20c may be part of a U-shaped profile 26c;
- the busbar portions 53a, 53b may each have an upright end-portion (extending in the YZ-plane) for easy connection with portions of the U-shaped profile 26c;
- sensor device 30c is mounted on lip 11c, and is located partially inside the opening 25c.

**FIG. 3B** shows the current sensor assembly 100 of FIG. 3A as a line drawing.

**FIG. 4** shows an enlarged view of how a sensor device 30 mounted on a lip or protrusion 11 of a PCB 10, can be inserted in an opening 25 formed in an electrical conductor portion 20.

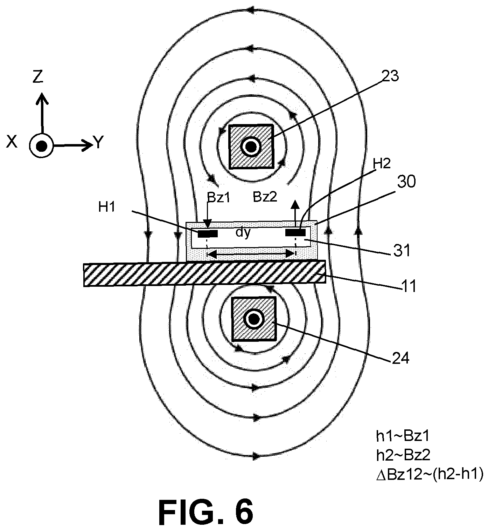

FIG. 4 also shows that the sensor device 30 may comprise at least two horizontal Hall elements H1, H2 spaced apart in the second direction Y for measuring a first magnetic field component Bz1 oriented in the Z-direction at a first sensor location, and for measuring a second magnetic field component Bz2 oriented in the Z-direction at a second sensor location, spaced at a distance dy from the first sensor location in the Y-direction. The distance dy may be a value in the range from about 0.5 to about 5.0 mm, preferably in the range from about 1.5 mm to about 3.0 mm, or in the range from 2.0 mm to 2.5 mm. The value of dy is not critical (as can be appreciated from FIG. 6).

In an embodiment, the sensor device 30 is configured for determining a difference ΔBz between the measured magnetic field components Bz1, Bz2, in the analog or digital domain. The sensor device 30 may be further configured for amplifying and/or digitizing this difference signal ΔBz. The amplified and optionally digitized difference signal may be output. It is also possible to first amplify and/or digitize the individual signals h1, h2 obtained from the horizontal Hall elements H1, H2, and to subtract the digitized values in the digital domain, and to output the result, optionally after digital-to-analog conversion (DAC).

The sensor device 30 may also be configured to convert the difference signal ΔBz into a current value, e.g. by scaling with a predefined constant which may be determined during a calibration procedure, and stored in a non-volatile memory. This scale value may be output instead of, or in addition to the difference signal ΔBz. If is of course also possible to output the individual signals Bz1, Bz2.

**FIG. 4** also shows that a width w11 of the lip 11 is preferably smaller than a size L23 (see FIG. 5) of the opening 25 measured in the X-direction, and that the total height of the lip 11 and the sensor device 30 is preferably smaller than a height H25 of the opening 25 measured in the Z-direction. In practice a small spacing (or airgap) of at least 0.5 mm on each side is preferred.

The interconnection portion 23 may have a cross-sectional area A23, and the interconnection portion 24 may have a cross-sectional area A24, in a plane YZ. A ratio (A23/A24) of these cross-sectional areas is preferably a value in the range from 50% to 200%, more preferably a value in the range from 75% to 150%, or from 80% to 120%, or from 90% to 110%, or from 95% to 105%.

In the example shown, the opening 25 has a rectangular cross-section (in the plane XZ), but that is not absolutely required, and an opening with e.g. a circular cross-section would also work.

**FIG.** 5 shows an enlarged view of an electrical conductor portion 20 as can be used in embodiments of the present invention.

In the example shown in FIG. 5, the conductor portion 20 has a constant thickness (measured in the Y-direction), and each of the main body portions 21, 22 and each of the interconnection portions 23, 24 have a rectangular cross-section in a plane XZ, and the two interconnection portions 23, 24 are spaced apart in the third direction Z.

The two main body portions 21, 22 may have cross-sectional areas A21, A22 in a plane YZ, which are larger than the sum of the cross-sectional areas (A23+A24) of the interconnection portions 23, 24. Thus, the current density of the current flowing through the interconnection portions 23, 24 is locally increased, thus increasing the signal-to-noise ratio (SNR) of the measured signals.

**FIG.** 6 gives a qualitative impression of the magnetic field lines induced by the currents flowing through the interconnection portions 23, 24. The currents flow in the X-direction, and the magnetic field lines are shown in a virtual plane YZ. FIG. 6 shows a sensor device 30 which is mounted on a lip or protrusion 11 of a PCB. The lip or protrusion 11 and the sensor device 30 are at least partially located inside the space 25 between the two interconnection portions 23, 24. In the example shown, the sensor device 30 comprises a single semiconductor substrate 31 comprising two magnetic sensor elements H1, H2 spaced apart in the Y-direction, for measuring two magnetic field components Bz1, Bz2.

As described above, the current sensor system 100 of FIG. 1A comprises three sensor devices 30a, 30b, 30c, each arranged at least partially inside a respective opening 25a, 25b, 25c for measuring two magnetic field components oriented in the Z-direction at two different locations spaced apart in the Y-direction. Each sensor device may output for example the two measured magnetic field component values and/or a difference value ΔBz, and/or a value proportional to ΔBz, e.g. indicative of the individual current flowing through the respective busbar.

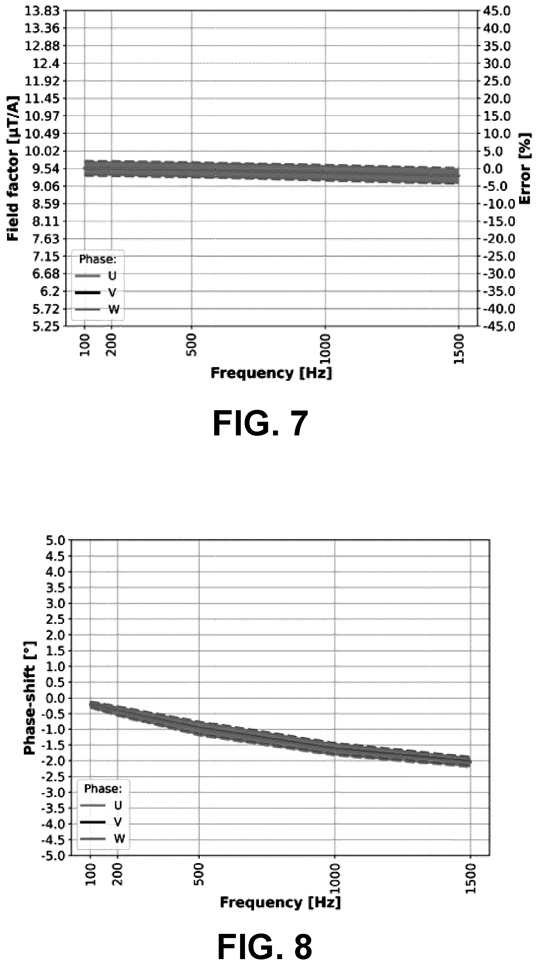

FIG. 7 shows a graph with simulation results showing the magnitudes of the three magnetic difference signals or values (ΔBz) as would be measured by the three sensor devices 30a, 30b, 30c of the three-phase current sensor system 100 of FIG. 1A, when three 120° phase shifted currents with a predefined amplitude and with frequencies ranging from 100 Hz to 1500 Hz are flowing through the conductor portions 20a, 20b, 20c without using magnetic shielding and without using post-processing calculations (e.g. for cross-talk compensation). In the simulations, the length L23 and height H25 of the openings 25 was equal to about 7.3 mm x 8 mm, but of course, other dimensions can be used as well.

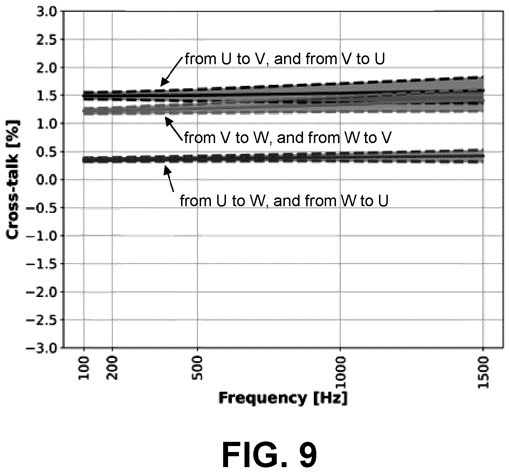

As can be seen, there is a small amplitude error in the range from about -5.0% to about +2.5% for frequencies up to 1500 Hz, due to mechanical mounting tolerances, and due to cross-talk between the different phases. It is noted, that this amplitude error can be further reduced if so desired, e.g. by active cross-talk compensation, as will be described further (e.g. when discussing FIG. 9 and FIG. 13A).

**FIG.** 8 shows a graph with simulation results showing the phase shift of the three magnetic difference signals or values (ΔBz) as would be measured by the three sensor devices 30a, 30b, 30c of the three-phase current sensor system 100 of FIG. 1A for the same configuration as was used in FIG. 7.

As can be seen, there is a small phase error in the range from about 0° to about -2.2° for frequencies up to 1500 Hz, due to mechanical mounting tolerances, and due to cross-talk between the different phases. It is noted, that this phase error can be further reduced if so desired, e.g. by active cross-talk compensation, as will be described further (e.g. when discussing FIG. 9 and FIG. 13A).

**FIG.** 9 shows a graph with simulation results showing the amount of cross-talk of the three magnetic difference signals (ΔBz) as would be measured by the three sensor devices 30a, 30b, 30c of the three-phase current sensor system 100 of FIG. 1A, for the same configuration as was used in FIG. 7.

As can be seen, the cross-talk between the phases U and W is smaller than the cross-talk between the phases U & V, or between V & W, mainly because the distance between U and W is larger.

Surprisingly, the cross-talk between each pair of phases is rather constant, and only slightly dependent on frequency. This makes it possible to reduce the cross-talk between the various phases by simple mathematical calculations, e.g. as illustrated in FIG. 13A, e.g. using simple matrix calculations, or e.g. using three linear combinations of three terms with predefined coefficients.

**FIG. 10** is a schematic representation of a variant of FIG. 1A wherein the electrical conductor portions have a U-shape, and the busbar portions have an L-shape, and where the ends of the electrical conductor portions are soldered or welded to the ends of the busbar portions.

**FIG.** 11 is a schematic representation of a variant of FIG. 1A wherein the electrical conductor portions have a U-shape, and the busbar portions have an L-shape, and where the ends of the electrical conductor portions are connected to the ends of the busbar portions using fastening means like bolts or rivets or the like.

**FIG. 12** is an illustrative example of a busbar portion 51a that is twisted about its longitudinal axis, as may be used in embodiments of the present invention. By twisting the busbar twice over an angle of about 90° (only one such twist is shown in FIG. 12), the horizontal orientation of the busbar can be locally converted into an upright orientation (similar to the orientation of the electrical conductor portions 20 of FIG. 1A). An opening can be made in the upright portion, e.g. by punching or by drilling, and a lip 11 of a PCB with a sensor device 30 mounted on top can then be inserted in said opening, in much the same way as illustrated in FIG. 1A.

A three-phase current sensor system comprising three such busbars and a PCB similar to the one shown in FIG. 1A is also contemplated.

**FIG. 13A** shows an illustrative example of a printed circuit board with three sensor devices 30a, 30b, 30C mounted thereon, as can be used in the current sensor assembly 100 described above, and illustrated in FIG. 1A.

The PCB 1310a of FIG. 13A has three U-shaped cut-outs 44a, 44b, 44c, and each of the lips 11a, 11b, 11c has a rectangular shape with four sides. The lips are free on three sides, and are connected to the PCB on one side. The three lips 11a, 11b, 11c are preferably located on a single virtual axis oriented in the Y-direction. The three sensor devices 30a, 30b, 30c are spaced apart from each other in the Y-direction two of these cut-outs 44b, 44c. In the example of FIG. 13A, each sensor device 30a, 30b, 30c comprises two horizontal Hall elements (H1,H2); (H3,H4); (H5,H6) which are preferably located on said single virtual axis oriented in the Y-direction.

The sensor signals h1 to h6 provided by these horizontal Hall elements H1 to H6 are indicative of magnetic field components Bz1 to Bz6 oriented in the Z-direction.

In preferred embodiments, three magnetic field differences ΔBz12, ΔBz34, ΔBz56 are derived from these sensor signals h1 to h6, e.g. in accordance with the set of formulas [13-1].

In an embodiment, each sensor device 30 determines a magnetic field difference signal, and outputs a current value proportional to this magnetic field difference signal. For example, sensor device 30a measures Bz1 and Bz2, and calculates ΔBz12 as a value proportional to (h2-h1), and outputs a value for the first current lu, e.g. in accordance with the formula lu=K1*ΔBz12. Likewise, sensor device 30b can output a value for the current Iv, and sensor device 30c can output a value for the current Iw. As described above (see FIG. 7 to FIG. 9) these current values are highly accurate for frequencies up to about 1500 Hz.

It is possible, however, to further improve the accuracy of the measured currents by calculating each current as a function of the three difference values ΔBz12, ΔBz34, ΔBz56, e.g. in accordance with the formulas of eq. [13-2], where f1, f2, f3 are predefined functions.

Each current lu, Iv, Iw can for example be calculated as a polynomial expression of the magnetic field difference values ΔBz12, ΔBz34, ΔBz56, using a set of predefined coefficients which can be determined by simulation, or during a calibration procedure. These coefficients can be stored in a non-volatile memory (e.g. flash) embedded in, or connected to the processor or controller chip 41 during the calibration procedure, and can be retrieved from said non-volatile memory during actual use.

In a preferred embodiment, each current lu, Iv, Iw is determined as a linear combination of the three magnetic field difference values ΔBz12, ΔBz34, ΔBz56, e.g. in accordance with the formulas of eq. [13-3], using a set of predefined coefficients, which can be determined by simulation, or during a calibration procedure. These coefficients may be stored in a non-volatile memory (e.g. flash) embedded in, or connected to the processor or controller chip 41 during the calibration procedure, and can be retrieved from said non-volatile memory during actual use.

The accuracy of the current values lu, Iv, Iw determined using the set of eq. [13-3] can be more accurate than the current values determined using the set of eq. [13-4], because the set [13-3] allows to actively reduce cross-talk in a very simple manner.

As already mentioned above, the PCB 1310a may also contain other electrical or mechanical components, such as e.g. one or more of the following: power transistors 42a, 42b, 42c, electrical connectors, capacitors, voltage generators, etc.

In a variant, the PCB comprises only two sensor devices, and the sets of equations comprise only two formulas instead of three.

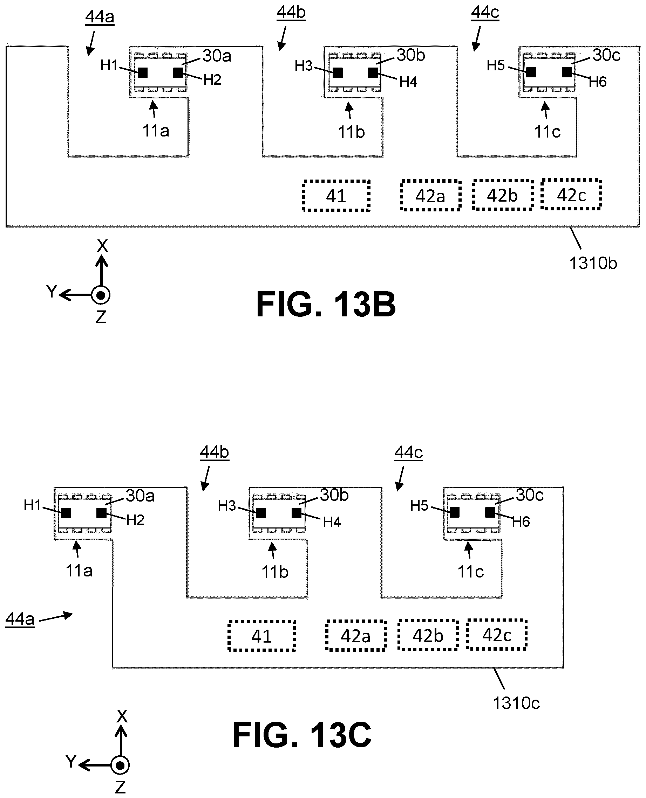

**FIG. 13B** shows another illustrative example of a printed circuit board 1310b with three sensor devices 30a, 30b, 30C, as can be used in the current sensor assembly 100 of FIG. 1A. The PCB 1310b can be seen as a variant of the PCB 1310a of FIG. 13A having three L-shaped cut-outs 44a, 44b, 44c instead of three U-shaped cut-outs. Everything else mentioned above for FIG. 13A is also applicable here, mutatis mutandis.

**FIG. 13C** shows a PCB 1310c as yet another variant of the PCB 1310a of FIG. 13A. The PCB 1310c has one rectangular cut-out 44a and two L-shaped cut-outs 44b, 44c. Everything else mentioned above for FIG. 13A is also applicable here, mutatis mutandis.

**FIG. 13D** shows two printed circuit boards 10d1 and 10d2 as yet another variant of the PCB 1310a of FIG. 13A. The printed circuit board 10d1 has one lip 11a, and one cut-out 44a, and comprises one sensor device 30a. The printed circuit board 10d2 comprises two lips 11b, 11c, and two cut-outs 44a, 44c, and comprises two sensor devices 30b, 30c. The PCBs 10d1, 10d2 are preferably interconnected by means of wires or a flex cable 46. In the example only three wires or cables are shown, but of course another number of wires or cables can also be used. In the example, the PCB 10d2 may further comprise a controller device 41 and/or power transistors 42a to 42c. Everything else mentioned above for FIG. 13A is also applicable here, mutatis mutandis.

**FIG. 13E** shows three printed circuit boards 10e1, 10e2, 10e3, each having one lip 11a, 11b, 11c and one sensor device 30a, 30b, 30c and one cut-out 44a, 44b, 44c. These three PCBs are preferably interconnected, e.g. using connectors 45c to 45f and wires or cables 46b, 46c. Everything else mentioned above for FIG. 13A is also applicable here, mutatis mutandis.

**FIG. 14** shows a high-level block-diagram of a electrical circuit that may be implemented on one or more printed circuit boards proposed by the present invention, e.g. the board 10 of FIG. 1A, or on the printed circuit boards 1310a to 1310c illustrated in FIG. 13A to FIG. 13C, or on the printed circuit boards 10d1, 10d2 of FIG. 13D, or on the printed circuit boards 10e1, 10e2, 10e3 of FIG. 13E.

The circuit of FIG. 14 comprises a controller device 41 and at least two or at least three sensor devices 30a, 30b, 30c communicatively connected to the controller device 41.

Each of the sensor devices comprises at least one semiconductor substrate with two magnetic sensor elements, (e.g. at least two horizontal Hall elements), and a biasing and readout circuit, and an amplifier, and preferably at least one temperature sensor T for measuring a temperature of the semiconductor substrate, which temperature can be used for sensitivity correction. The sensor devices may optionally further comprise: an analog-to-digital convertor (ADC), a processing circuit, a non-volatile memory, etc. The sensor devices 30 may be configured for providing one or more of the following signals to the controller chip or processor 41: an analog or digital version of the measured sensor signals (e.g. h1, h2), an analog or digital version of the difference signal (e.g. ΔBz12), an analog or digital version of the uncorrected current signal (e.g. K1*ΔBz12).

If the sensor device 30a comprises a digital processor, then it preferably also comprises an analog-to-digital convertor and a non-volatile memory. The latter may contain one or more predefined constants, e.g. conversion factor (e.g. K1) for converting a difference signal into a current signal, e.g. in accordance with the set of eq. [13-4]. And similar for the other sensor devices 30b, 30c.

The controller device 41 may comprise an analog-to-digital convertor, a digital processor, a non-volatile memory, one or more PWM modules (pulse-width modulation), etc. It is also possible to store the predefined constants (e.g. the coefficients of eq. [13-3] or of eq. [13-4]) in the non-volatile memory of the controller device 41.

The controller device 41 may have multiple output ports, and may be configured to generate a plurality of control signals to drive one or more on-board or off-board power transistors (not explicitly shown) in known manners.

The principles of the present invention are explained and illustrated mainly for an assembly comprising three busbar and a single printed circuit board, but the present invention is not limited thereto, and also works for an assembly having only two busbars, or four busbars, or more than four busbars, and/or having two printed boards or three printed circuit boards, optionally electrically connected together, e.g. via a set of cables.

### References:

- 00: current sensor assembly
- 10: printed circuit board (PCB)
- 11: lip or protrusion
- 20: electrical conductor portion
- 21, 22: main body portions
- 23, 24: interconnection portions
- 25: opening
- 26: U-shaped conductor portion
- 30: sensor device
- 31: semiconductor substrate
- 41: processor or controller chip
- 42: power transistor(s)
- 44: cut-out in the PCB
- 45: electrical connector (e.g. flex connector)
- 46: electrical connection (e.g. cables or flex cable)
- 51a, 51b: first, second part of first busbar
- 52a, 52b: first, second part of second busbar
- 53a, 53b: first, second part of third busbar
- H1, H2,: first, second, ... Horizontal Hall element
- h1, h2,: signal obtained from H1, H2, ...
- W11: width of the lip (measured in X-direction)
- L23: Length of the opening (measured in the X-direction)
- H25: height of the opening (measured in the Z-direction)

## Claims

1. A current sensor assembly (100; 100d; 100e) comprising:
- a plurality of at least two electrical conductor portions (20a, 20b, 20c) for conducting at least two electrical currents (Iu, Iv, Iw),
each of said at least two electrical conductor portions (20) having two main body portions (21, 22) and two interconnection portions (23, 24) disposed between the two main body portions (21, 22), the two interconnection portions (23, 24) being spaced apart and extending in a first direction (X) so as to form an opening (25) between them;
- one or more printed circuit boards (10; 10d1,10d2; 10e1,10e2,10e3) located in a virtual plane extending parallel to the first direction (X) and parallel to a second direction (Y) perpendicular to the first direction (X), the one or more printed circuit boards together comprising at least two lips or protrusions (11),
each lip or protrusion (11) accommodating a sensor device (30);
each sensor device (30) having at least three electrical contacts connected to the one or more printed circuit boards (10; 10d1,10d2; 10e1,10e2,10e3);
each sensor device (30) being or comprising a semiconductor substrate (31) oriented parallel to the one or more printed circuit boards (10);
each sensor device (30) being arranged at least partially inside the opening (25) of a respective electrical conductor portion (20);
each sensor device (30a, 30b, 30c) comprising a plurality of magnetic sensing elements (H1,H2; H3,H4; H5,H6) for measuring at least two magnetic field components (Bz1,Bz2; Bz3,Bz4; Bz5,Bz6) oriented in a third direction (Z) perpendicular to the semiconductor substrate (10) at two sensor locations spaced apart in the second direction (Y).

2. A current sensor assembly (100; 100d; 100e) according to claim 1,
wherein each of the at least two electrical conductor portions (20a, 20b) is an integral part of a U-shaped profile (26a, 26b).

3. A current sensor assembly (100; 100d; 100e) according to any of the previous claims,
wherein the at least two electrical conductor portions (20a, 20b) comprise a first electrical conductor portion (20a) and a second electrical conductor portion (20b);
and wherein the first electrical conductor portion (20a) has a first end electrically connected to a first busbar portion (51a), and a second end electrically connected to a second busbar portion (51b) for electrically interconnecting said first and second busbar portion (51a, 51b) and for measuring a first current (Iu) flowing through said first and second busbar portion (51a, 51b);
and wherein the second electrical conductor portion (20b) has a third end electrically connected to a third busbar portion (52a), and a fourth end electrically connected to a fourth busbar portion (52b) for electrically interconnecting said third and fourth busbar portion (52a, 52b) and for measuring a second current (Iv) flowing through said third and fourth busbar portion (52a, 52b).

4. A current sensor assembly (100; 100d; 100e) according to claim 3,
wherein each of the first and second electrical conductor portion (20a, 20b) is a planar metallic profile extending mainly in the first direction (X) and the third direction (Z);
and wherein each of the first, second, third and fourth busbar portion (51a, 51b, 52a, 52b) is a planar metallic profile extending mainly in the first direction (X) and the second direction (Y).

5. A current sensor assembly (100; 100d; 100e) according to claim 3 or 4,
wherein said electrical conductor portions (20a, 20b) are oriented substantially perpendicular to said busbar portions (51a, 51b, 52a, 52b);
and wherein said one or more printed circuit boards (10; 10d1,10d2; 10e1,10e2,10e3) are oriented substantially perpendicular to said electrical conductor portions (20a, 20b) and substantially parallel to said busbar portions (51a, 51b, 52a, 52b).

6. A current sensor assembly (100; 100d; 100e) according to any of the previous claims,
wherein at least one of the one or more printed circuit boards has at least one cut-out (44a, 44b) having a predefined shape selected from the group consisting of: a U-shape, an L-shape, or a rectangular shape.

7. A current sensor assembly (100; 100d; 100e) according to any of the previous claims,
wherein each of said at least two sensor devices (30a, 30b) comprises at least two horizontal Hall elements (H1, H2) spaced apart in the second direction (Y).

8. A current sensor assembly (100; 100d; 100e) according to any of the previous claims,
wherein at least one of the one or more printed circuit boards (10; 10d1,10d2; 10e1,10e2,10e3) further comprises a controller device (41) electrically connected to each of said at least two sensor devices (30a, 30b).

9. A current sensor assembly (100; 100d; 100e) according to claim 8,
wherein each sensor device (30) is configured for providing a value indicative of a magnetic field difference (ΔBz) to the controller device (41);
and wherein the controller device (41) is configured for receiving at least two values indicative of two magnetic field difference , and for determining at least a first and a second current (Iu, Iv) based on the received values.

10. A current sensor assembly (100; 100d; 100e) according to claim 9,
wherein the controller device (41) is configured for determining said first and said second current as a linear combination of the received values, using predefined coefficients.

11. A current sensor assembly (100; 100d; 100e) according to any of the previous claims,
wherein the plurality of electrical conductor portions (20a, 20b, 20c) are spaced apart in the second direction (Y);
and wherein the two interconnection portions (23, 24) of each individual conductor portion (20a, 20b, 20c) are spaced apart in the third direction (Z);
and wherein the lips (11a, 11b, 11c) of the one or more printed circuit boards (10; 10d1,10d2; 10e1,10e2,10e3) extend in the second direction (Y), and are spaced apart in the second direction (Y).

12. A current sensor assembly (100; 100d; 100e) according to any of the previous claims,
wherein the sensor devices (30) are packaged in a surface-mount package, e.g. SOIC-package, or a QFN package, or a DFN package or a SON Package.

13. A printed circuit board (10; 1310a; 1310b; 1310c; 10d2)
having a surface extending in a first direction (X) and a second direction (Y) perpendicular to the first direction;
and comprising at least two cut-outs (44a, 44b, 44c) and at least two lips or protrusions (11a, 11b, 11c) extending in the second direction (Y), and being spaced apart in the second direction (Y);
each lip or protrusion(11) accommodating a sensor device (30a, 30b, 30c);
each sensor device (30) comprising a plurality of magnetic sensor elements (H1,H2; H3,H4; H5,H6) configured for measuring at least two magnetic field components (Bz1, Bz2) oriented in a third direction (Z) perpendicular to the printed circuit board at two sensor locations which are spaced apart in the second direction (Y).

14. A printed circuit board ((10; 1310a; 1310b; 1310c; 10d2) according to claim 13,
wherein the lips (11a, 11b, 11c) have a rectangular shape or a trapezoidal shape or a triangular shape or a dome shape or a bulb shape or a semi-elliptical shape;
and/or wherein the cut-outs (44a, 44b, 44c) have a predefined shape selected from the group consisting of: a U-shape, an L-shape, a rectangular shape.

15. A power inverter comprising a current sensor assembly (100; 100d; 100e) according to any of the claims 1 to 12, and/or comprising a printed circuit board (10; 1310a; 1310b; 1310c; 10d2) according to any of the claims 13 to 14.
